# EUROPÄISCHE PATENTSCHRIFT

(11) **EP 2 927 940 B1**
(45) Veröffentlichungstag und Bekanntmachung des Hinweises auf die Patenterteilung: **21.08.2019**
(21) Anmeldenummer: 15157691.5
(22) Anmeldetag: 05.03.2015
(51) Int. Cl.: H01L 21/48, B23K 20/10

(54) **VORRICHTUNG ZUR SCHWEISSTECHNISCHEN VERBINDUNG VON ANSCHLUSSELEMENTEN MIT DEM SUBSTRAT EINES LEISTUNGSHALBLEITERMODULS UND ZUGEHÖRIGES VERFAHREN**
DEVICE FOR WELDING TOGETHER CONNECTION ELEMENTS WITH THE SUBSTRATE OF A POWER SEMICONDUCTOR MODULE AND ASSOCIATED METHOD
DISPOSITIF DESTINÉ À LA LIAISON PAR TECHNIQUE DE SOUDAGE D'ÉLÉMENTS DE CONNEXION AU SUBSTRAT D'UN MODULE SEMI-CONDUCTEUR DE PUISSANCE ET PROCÉDÉ ASSOCIÉ

(30) Priorität: 31.03.2014 DE 102014104496
(43) Veröffentlichungstag der Anmeldung: 07.10.2015
(73) Patentinhaber: SEMIKRON Elektronik GmbH & Co. KG, 90431 Nürnberg (DE)
(72) Erfinder: Tauscher, Björn, 91183 Abendberg (DE); Fries, Stefan, 90469 Nürnberg (DE)

(56) Entgegenhaltungen:
- EP-A2- 1 011 132
- DE-A1-102012 213 567
- US-A- 3 650 454
- US-A- 5 195 237
- US-A1- 2013 069 216
- US-B2- 7 424 966
- ROEDER E ET AL: "NEUE WERKSTOFFVERBUNDE DURCH ULTRASCHALLSCHWEISSEN", TECHNOLOGIE UND MANAGEMENT, EXPERPRESS-VERLAG, BERLIN, DE, Bd. 44, Nr. 1, 1. Januar 1995 (1995-01-01) , Seiten 31-37,39, XP008011382, ISSN: 0932-2558

## Beschreibung

Die Erfindung beschreibt eine Vorrichtung zur schweißtechnischen Verbindung von Anschlusselementen mit einem Substrat, insbesondere mit einer Leiterbahn des Substrats, insbesondere mit dem Substrat eines Leistungshalbleitermoduls, sowie ein Verfahren zur Herstellung eines Leistungshalbleitermoduls mittels einer derartigen Vorrichtung. Unter dem Begriff der schweißtechnischen Verbindung, kurz Schweißverbindung, soll hier und im Folgenden jegliche Art von Schweißverbindung, insbesondere Ultraschallschweißverbindungen und verwante Verbindungsarten, allerdings explizit nicht eine Drahtbondverbindung, wie sie als Dünn- oder Dickdrahtbondverbindungen fachüblich sind, verstanden werden.

Aus dem Stand der Technik, beispielhaft offenbart in der DE 101 03 084 A1, ist ein Leistungshalbleitermodul mit wenigstens einem Leistungshalbleiterbauelement bekannt, wobei das Leistungshalbleiterbauelement unmittelbar auf einem Substrat angeordnet ist, welches einen Isolierstoffkörper und eine auf der dem Leistungshalbleiterbauelement zugewandten Oberseite angeordnete, mit dem Isolierstoffkörper fest verbundene Metallschicht aufweist, wobei wenigstens ein Anschlusselement des Leistungshalbleitermoduls mit der Metallschicht mittels Schweißen verbunden ist. Weiterer Stand der Technik ist in der Offenlegungsschrift DE102012213567 beschrieben.

Eine fachübliche Ausgestaltung einer Vorrichtung zur schweißtechnischen Verbindung von Anschlusselementen mit Leiterbahnen eines Substrats weist ein metallisches Widerlager zur Anordnung eines Bodenelements, das als eine Grundplatte mit einem darauf befindlichem Substrat oder nur als ein Substrat ausgebildet sein kann, eine Halteeinrichtung, die dazu ausgebildet ist das Bodenelement auf dem Widerlager zu fixieren sowie eine Sonotrode auf. Es kann zudem eine Positioniereinrichtung zur Positionierung des Anschlusselements zum Substrat vorgesehen sein.

Grundsätzlich problematisch ist es, dass bei der Ausführung einer Schweißverbindung mittels einer fachüblichen Vorrichtung durch die Einleitung der Energie mittels der Sonotrode auf das Anschlusselement die Verbindung zwischen der Metallschicht, die fachüblich Leiterbahnen ausbildet, und dem Isolierstoffkörper vorgeschädigt oder beschädigt wird. Hierbei kann sich diese Verbindung zwischen Isolierstoffkörper und Leiterbahn bei der Verwendung des Leistungshalbleitermoduls zumindest lokal lösen. Hierdurch kann zumindest die Dauerhaltbarkeit des Leistungshalbleitermoduls beschränkt werden.

In Kenntnis der genannten Gegebenheiten liegt der Erfindung die Aufgabe zugrunde, eine verbesserte Vorrichtung zur schweißtechnischen Verbindung von Anschlusselementen mit einem Substrat sowie ein Verfahren zur Herstellung eines Leistungshalbleitermodul unter Anwendung einer derartigen Vorrichtung vorzustellen.

Diese Aufgabe wird erfindungsgemäß gelöst durch eine Vorrichtung mit den Merkmalen des Anspruchs 1, sowie durch ein Leistungshalbleitermodul mit den Merkmalen des Anspruchs 10. Bevorzugte Ausführungsformen sind in den jeweiligen abhängigen Ansprüchen beschrieben.

Die erfindungsgemäße Vorrichtung zur schweißtechnischen Verbindung eines Anschlusselements, insbesondere des Anschlusselements eines Leistungshalbleitermoduls, mit einer Leiterbahn eines Substrats, insbesondere der Leiterbahn des Leistungshalbleitermoduls, umfasst:
- ein Widerlager zur Anordnung eines Bodenelements, das als ein Substrat oder als eine Grundplatte mit einem darauf befindlichem Substrat ausgebildet ist, wobei das Widerlager ein erstes und ein zweites Teilwiderlager aufweist, wobei das erste Teilwiderlager ein metallischer Formkörper mit einem Elastizitätsmodul zwischen 50 und 300 kN/mm² ist und das zweite Teilwiderlager ein elastischer Formkörper mit einem Elastizitätsmodul zwischen 10 und 500 N/mm² ist und wobei das Bodenelement auf dem zweiten Teilwiderlager, insbesondere ausschließlich hierauf, aufliegt;
- eine Halteeinrichtung, die dazu ausgebildet ist das Bodenelement auf dem Widerlager zu fixieren;
- eine Sonotrode;
- eine Positioniereinrichtung zur Positionierung des Anschlusselements derart zum Substrat, dass ein Kontaktfuß des Anschlusselements auf einer Kontaktstelle einer Leiterbahn des Substrats aufliegt und mittels der Sonotrode damit verbunden wird.

Es ist besonders bevorzugt, wenn der Elastizitätsmodul des zweiten Teilwiderlagers zwischen 25 und 100 N/mm² liegt.

Es ist weiterhin bevorzugt, wenn das erste und das zweite Teilwiderlager mechanisch, vorzugsweise mittels einer Schraubverbindung, miteinander verbunden sind.

Hierbei kann das zweite Teilwiderlager eine Mindestdicke von 0,2 cm, vorzugsweise von 1 cm aufweisen.

Besonders vorteilhaft ist es wenn die Halteeinrichtung als eine mechanische Klemmeinrichtung und alternativ oder zusätzlich als pneumatische Ansaugeinrichtung ausgebildet ist.

Ebenso kann es bevorzugt sein, wenn die Kontaktstelle mindestens eine Fläche von 2 mm², vorzugsweise von 5 mm², aufweist.

Insbesondere bevorzugt ist es, wenn das zweite Teilwiderlager eine Härte von Shore-A 60 bis Shore-D 80, vorzugsweise von Shore-A 80 bis Shore-A 95, aufweist.

Vorteilhafterweise besteht das zweite Teilwiderlager aus einem Kunststoff, vorzugsweise einem Polyurethan, vorzugsweise einem Polyurethan-Elastomer, vorzugsweise einem Polyurethan-Elastomer auf Polyetherbasis.

Bei dem erfindungsgemäßen Verfahren zur Herstellung eines Leistungshalbleitermoduls mit einem Bodenelement, das als ein Substrat oder als eine Grundplatte mit einem darauf befindlichem Substrat ausgebildet ist, mit ein Anschlusselement, das insbesondere aus Kupfer oder einer Kupferlegierung besteht, zur elektrischen Verbindung, wobei das Anschlusselement ein Kontaktfuß aufweist, wird der Kontaktfuß mit einer zugeordneten Kontaktstelle einer Leiterbahn, die insbesondere aus Kupfer oder einer Kupferlegierung besteht, des Substrats schweißtechnisch verbunden.

Selbstverständlich wird hier unter dem Begriff Anschlusselement auch eine Mehrzahl von Anschlusselementen auch von Anschlusselementen verschiedener Funktionalität, wie beispielhaft internen oder nach außen führenden Last- oder Hilfsanschlusselementen verstanden.

Es kann bevorzugt sein, wenn das Bodenelement in Längsrichtung mindestens eine erste Vorbiegung aufweist. Gleichzeitig oder alternativ kann es bevorzugt sein, wenn das Bodenelement in Querrichtung mindestens eine zweite Vorbiegung aufweist.

Es versteht sich, dass die verschiedenen Ausgestaltungen der Erfindung, also der Vorrichtung wie auch des Herstellungsverfahren und des damit hergestellten Leistungshalbleitermoduls, einzeln oder in beliebigen Kombinationen realisiert sein können, um Verbesserungen zu erreichen. Insbesondere sind die vorstehend genannten und hier oder im Folgenden erläuterten Merkmale nicht nur in den angegebenen Kombinationen, sondern auch in anderen Kombinationen oder in Alleinstellung einsetzbar, ohne den Rahmen der vorliegenden Erfindung zu verlassen.

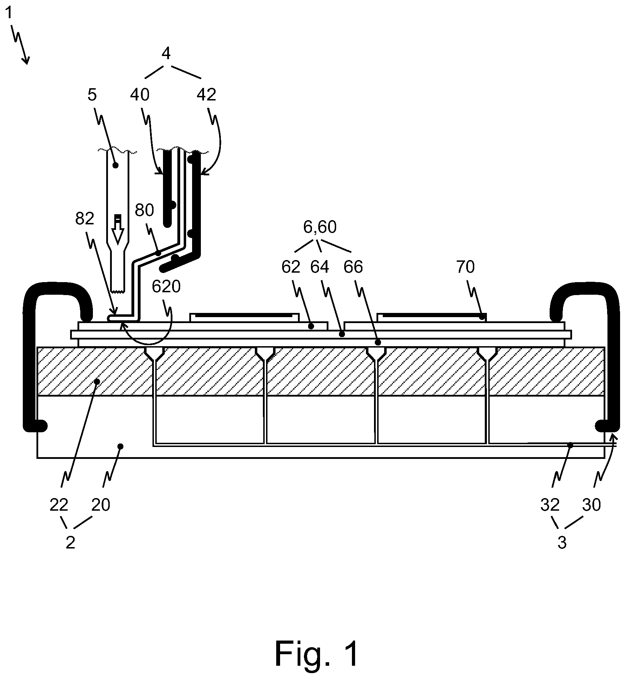

Weitere Erläuterungen der Erfindung, vorteilhafte Einzelheiten und Merkmale, ergeben sich aus der nachfolgenden Beschreibung der in den Figuren 1 bis 4 schematisch dargestellten Ausführungsbeispiele der erfindungsgemäßen Vorrichtung, des erfindungsgemäß hergestellten Leistungshalbleitermoduls oder von jeweiligen Teilen hiervon.
Figur 1 zeigt eine erste Ausgestaltung der erfindungsgemäßen Vorrichtung mit einem angeordneten Substrat eines Leistungshalbleitermoduls.
Figur 2 zeigt eine zweite Ausgestaltung der erfindungsgemäßen Vorrichtung mit einer Grundplatte mit einem darauf befindlichem Substrat eines Leistungshalbleitermoduls.
Figur 3 zeigt eine Draufsicht wie auch einen Schnitt durch eine Grundplatte mit darauf befindlichen Substraten eines ersten erfindungsgemäß hergestellten Leistungshalbleitermoduls.
Figur 4 zeigt eine Draufsicht wie auch einen Schnitt durch eine Grundplatte mit darauf befindlichen Substraten eines zweiten erfindungsgemäß hergestellten Leistungshalbleitermoduls.

Figur 1 zeigt eine erste Ausgestaltung der erfindungsgemäßen Vorrichtung 1 mit einem angeordneten Substrat 60 eines Leistungshalbleitermoduls. Dargestellt ist ein Widerlager 2 bestehend aus einem ersten und einem zweiten Teilwiderlager 20, 22. Das erste Teilwiderlager 20 entspricht bevorzugt in seiner wesentlichen Ausgestaltung einem fachüblichen Widerlager für Schweißverbindungen, insbesondere Ultraschallschweißverbindungen. Dieses erste Teilwiderlager 20 besteht hier aus einem Metallformkörper, insbesondere einem Stahlkörper.

Mit diesem ersten Teilwiderlager 20 ist das zweite Teilwiderlager 22 kraftschlüssig, mittels fachüblicher Schraubverbindungen verbunden. Dieses zweite Teilwiderlager 22 bildet an seiner dem ersten Teilwiderlager 20 abgewandten Oberfläche die Auflagefläche für einen mittels einer Schweißverbindung zu verbindenden Gegenstand, hier ein Bodenelement 6 eines Leistungshalbleitermoduls aus.

Weiterhin dargestellt sind Halteinrichtungen 3 zur Fixierung dieses zu schweißenden Gegenstandes oder Teilen davon. Dargestellt sind zwei, hier zusammenwirkende Halteeinrichtungen 3, hier eine Klemmeinrichtung 30 wie auch eine pneumatische Ansaugeinrichtung 32, die gemeinsam zur kraftschlüssigen Halterung des Gegenstandes auf der Oberfläche des zweiten Teilwiderlagers 22 dienen.

Diese beiden Ausgestaltungen sind insbesondere dann von Vorteil, wenn der Gegenstand, das Bodenelement 6, selbst keine ausreichende mechanische Stabilität aufweist, um nur mittels einer der beiden Halteeinrichtungen 3 fixiert zu werden.

Andererseits ergänzen sich die beiden Halteeinrichtungen 30, 32 funktional bei jedem beliebigen Gegenstand.

Der auf der Oberfläche des zweiten Teilwiderlagers 22 angeordnete Gegenstand ist hier ein fachübliches Substrat 60 eines Leistungshalbleitermodul. Dieses Substrat 60 besteht hier ohne Beschränkung der Allgemeinheit aus einem Isolierstoffkörper 64, beispielhaft einer Industriekeramik mit auf beiden Hauptflächen angeordneten Metall-, vorzugsweise Kupferkaschierungen 62, 66. Diese Kupferkaschierungen 62, 66 bilden insbesondere auf der dem Widerlager 2 abgewandten Seite des Substrats 60 Leiterbahnen 62 des Leistungshalbleitermoduls aus.

Auf diesen Leiterbahnen 62 sind fachüblich Leistungshalbleiterbauelement 70 angeordnet und elektrisch leitend verbunden. Weitere nicht dargestellte Verbindungen verbinden diese Leistungshalbleiterbauelement 70 mit weiteren Leiterbahnen 62 des Substrats 60.

Die Schweißverbindung soll hier zwischen einer dieser Leiterbahnen 62 und einem Anschlusselement 80 des Leistungshalbleitermodul ausgebildet werden. Es handelt sich hier ohne Beschränkung der Allgemeinheit um eine Lastanschlusselement zur externen Verbindung des Leistungshalbleitermoduls. Dieses Lastanschlusselement 80 weist einen Kontaktfuß 82 auf, der mit einer zugeordneten Kontaktstelle 620 der Leiterbahn 62 des Substrats 60 verbunden werden soll.

Das Lastanschlusselement 80 ist einschließlich des Kontaktfußes 82 ausgebildet als ein Metallformkörper, vorzugsweise bestehend aus Kupfer mit einer fachüblichen nicht zwangsweise die gesamte Oberfläche bedeckenden metallischen Oberflächenbeschichtung bevorzugt aus Silber oder Nickel.

Die Vorrichtung 1 weist zur Positionierung dieses Lastanschlusselements 80 und insbesondere des Kontaktfußes 82 zur Kontaktstelle 620 der Leiterbahn 62 eine zweiteilige 40, 42 Positioniereinrichtung 4 auf. Diese Positioniereinrichtung 4 positioniert den Kontaktfuß 82 unmittelbar auf der Kontaktstelle 620 oder in minimalem Abstand hiervon.

Die Vorrichtung 1 weist weiterhin eine Sonotrode 5 zur Einleitung der Schweißenergie auf den Kontaktfuß 82 des Lastanschlusselements 80 auf. Hierzu wird die Sonotrode 5, angedeutet durch den Pfeil, auf die der Leiterbahn 62 abgewandte Seite des Kontaktfußes 82 aufgebracht und anschießend gemäß fachüblichen Ultraschallschweißverfahrens bewegt, wobei hierzu typisch aber nicht notwendig Frequenzen im Bereich zwischen 20kHz und 40kHz angewendet werden.

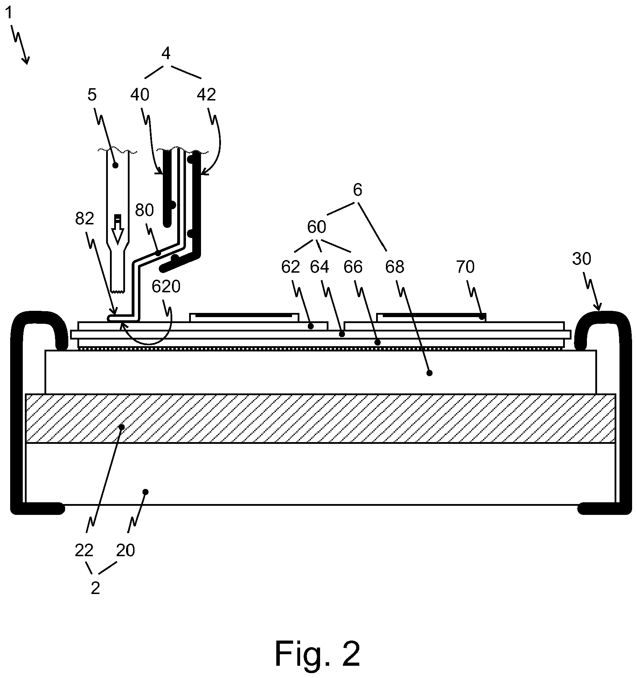

Figur 2 zeigt eine zweite Ausgestaltung der erfindungsgemäßen Vorrichtung 1 mit einem zu verbindenden Gegenstand, hier ein Bodenelement 6 eines Leistungshalbleitermoduls, das als eine Grundplatte 68 mit einem darauf befindlichem Substrat 60 ausgebildet ist. Diese Grundplatte 68 ist als ein Kupferquader ausgebildet, wie er für Leistungshalbleitermodule eine fachübliche Ausbildung der Grundplatte darstellt. Diese Grundplatte 68 weist eine mechanische Stabilität auf, die in dieser Ausgestaltung der Vorrichtung 1 eine Halteeinrichtung 3 in Form einer pneumatischen Ansaugeinrichtung nicht notwendig macht. Die Halteeinrichtung 3 ist daher hier, ohne Beschränkung der Allgemeinheit, nur als Klemmeinrichtung 30 ausgebildet, die hier Kraft direkt auf den Kupferquader 68 nicht aber auf das Substrat 60 ausübt.

Der zu verbindende Gegenstand ist hier bis auf den Kupferquader 68, also die Grundplatte unter dem Substrat 60 identisch mit demjenigen gemäß Figur 1. Es handelt sich hier somit um einen Teil eines Leistungshalbleitermoduls mit Grundplatte.

Mit dem Substrat wird analog zu Figur 1 ein Anschlusselement 80 verbunden, das ebenso wie die zugeordnete Positioniereinrichtung 4 und die Sonotrode 5 gemäß Figur 1 ausgestaltet sind.

Das Widerlager 2 ist ebenso gemäß Figur 1 ausgebildet weist hier allerdings wie erwähnt keine pneumatische Halteeinrichtung 32 auf.

Dadurch, dass das zweite Teilwiderlager 22 in beiden Ausgestaltungen als ein elastischer Formkörper mit einem Elastizitätsmodul zwischen 10 und 500 N/mm² ausgebildet ist, kann das Bodenelement 6, also entweder das Substrat 60 oder die Grundplatte 68 mit darauf angeordnetem Substrat 60, während des Schweißvorgangs eine stark gedämpfte Schwingung ausführen. Hierdurch wird der Schweißvorgang als solcher sanfter und Kraftspitzen wirken sich ebenso gedämpft auf die eigentliche Schweißverbindung aus. Hierdurch wird einerseits die Qualität der Verbindung verbessert und gleichzeitig die Vorschädigung eines zu verbindenden Gegenstands verhindert.

Insbesondere bei Substraten 60 von Leistungshalbleitermodulen, die aus einer Industriekeramik 64 mit auf beiden Hauptflächen angeordneten Metall-, vorzugsweise Kupferkaschierungen 62, 66, die zumindest auf einer Seite des Substrats Leiterbahnen 62 ausbildet, ist eine derartige schonende Schweißverbindung vorteilhaft. Die Kupferkaschierungen 62, 66 werden fachüblich unter anderem mittels eines Direktbondverfahrens mit dem Isolierstoffkörper 64 verbunden, wobei die Haftkraft der Metallkaschierung 62, 66 auf dem Isolierstoffkörper 64 begrenzt ist und bei zu hoher Krafteinwirkung zumindest lokal durch einen fachüblichen Schweißprozess überschritten werden kann. Dies führt häufig erst im Dauerbetrieb eines derart hergestellten Leistungshalbleitermoduls zu vorzeitigen Ausfällen, also zu einer reduzierten Lebensdauer. Die erfindungsgemäße Vorrichtung 1 verhindert diese Überbelastung der Verbindung der Leiterbahn 62 mit dem Isolierstoffkörper 64 während des Schweißvorgangs.

Im konkreten Fall der beiden Vorrichtungen 1 gemäß den Figuren 1 und 2 handelt es sich bei dem zweiten Teilwiderlager 22 um einen quaderförmigen Formkörper aus Polyurethan-Elastomer auf Polyetherbasis mit einer Dicke von 2 ± 0,2 cm, einer Shore-A Härte von 80 ± 5 und mit einem Elastizitätsmodul von 70 ± 10 N/mm².

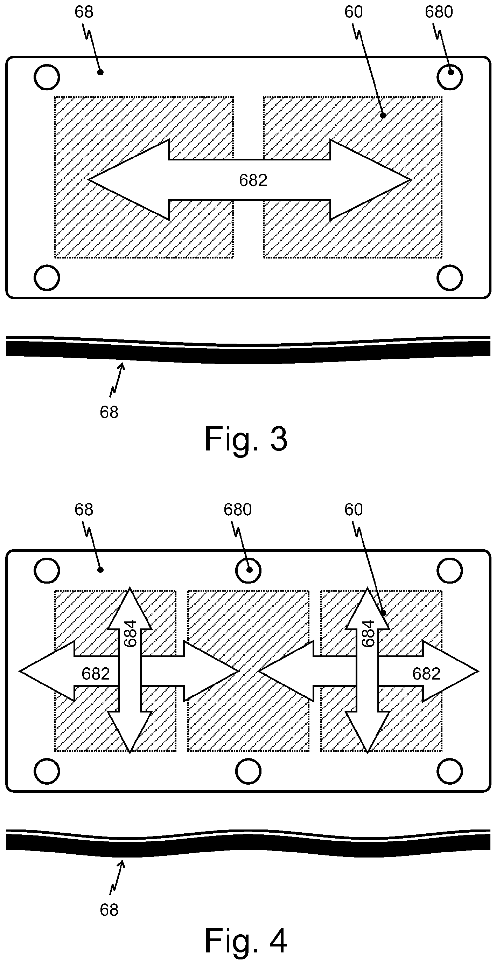

Figur 3 zeigt eine Draufsicht wie auch einen Schnitt durch eine Grundplatte 68 mit zwei darauf befindlichen Substraten 60 eines ersten erfindungsgemäß hergestellten Leistungshalbleitermoduls. Die Grundplatte 68 weist hierbei in ihren Ecken jeweils eine Ausnehmung 680 zur Befestigung auf einem Kühlkörper auf. Zum Ausgleich von thermisch induzierten Verspannungen während des Betriebs weist diese Grundplatte 68 in Längsrichtung eine erst Vorbiegung 682 derart auf, dass in der Mitte der Grundplatte eine Wölbung zu einem Kühlkörper hin ausgebildet ist. Eine derartige Wölbung soll hier als konvex bezeichnet werden und entlang des Doppelpfeiles ausgebildet sein, wobei das Maximum der Wölbung mittig zum Doppelpfeil liegt.

Figur 4 zeigt eine Draufsicht wie auch einen Schnitt durch eine Grundplatte 68 mit drei darauf befindlichen Substraten 60 eines zweiten erfindungsgemäß hergestellten Leistungshalbleitermoduls. Die Grundplatte 68 weist hierbei an ihren Längsseiten jeweils drei Ausnehmungen 680 zur Befestigung auf einem Kühlkörper auf. Zur Ausgleich von thermisch induzierten Verspannungen während des Betriebs weist diese Grundplatte in Längsrichtung zwei erste konvexe Vorbiegungen 682 und senkrecht dazu in Querrichtung zwei zweite konvexe Vorbiegungen 684 auf.

Die Leistungshalbleitermodule gemäß der Figuren 3 und 4 weisen weiterhin, ohne dargestellt zu sein, eine Mehrzahl von Lastanschlusselementen zur externen elektrischen Verbindung auf, wobei das jeweilige Lastanschlusselement einen Kontaktfuß aufweist, der mit einer zugeordneten Kontaktstelle einer Leiterbahn des Substrats 60 schweißtechnisch verbunden ist. Das jeweilige Lastanschlusselement besteht ebenso wie die Grundplatte der Leistungshalbleitermodule aus Kupfer.

## Patentansprüche

1. Vorrichtung (1) zur schweißtechnischen Verbindung eines Anschlusselements (80) mit einer Leiterbahn (62) eines Substrats (60), wobei die Vorrichtung aufweist:
• ein Widerlager (2) zur Anordnung eines Bodenelements (6), das als ein Substrat (60) oder als eine Grundplatte (68) mit einem darauf befindlichem Substrat (60) ausgebildet ist, wobei das Widerlager (2) ein erstes und ein zweites Teilwiderlager (20, 22) aufweist, wobei das erste Teilwiderlager (20) ein metallischer Formkörper mit einem Elastizitätsmodul zwischen 50 und 300 kN/mm² ist und das zweite Teilwiderlager (22) ein elastischer Formkörper mit einem Elastizitätsmodul zwischen 10 und 500 N/mm² ist und wobei das Bodenelement (6) auf dem zweiten Teilwiderlager (22) aufliegt;
• eine Halteeinrichtung (3), die dazu ausgebildet ist das Bodenelement (6) auf dem Widerlager (2) zu fixieren;
• eine Sonotrode (5);
• eine Positioniereinrichtung (4) zur Positionierung des Anschlusselements (80) derart zum Substrat (60), dass ein Kontaktfuß (82) des Anschlusselements (80) auf einer Kontaktstelle (620) einer Leiterbahn (62) des Substrats (60) aufliegt und mittels der Sonotrode (5) damit verbunden werden kann.

2. Vorrichtung nach Anspruch 1, wobei
das Bodenelement (6) ausschließlich auf dem zweiten Teilwiderlager (22) aufliegt.

3. Vorrichtung nach Anspruch 1 oder 2, wobei
der Elastizitätsmodul des zweiten Teilwiderlagers (22) zwischen 25 und 100 N/mm² liegt.

4. Vorrichtung nach einem der vorhergehenden Ansprüche, wobei
das erste und das zweite Teilwiderlager (20, 22) mechanisch, vorzugsweise mittels einer Schraubverbindung, miteinander verbunden sind.

5. Vorrichtung nach einem der vorhergehenden Ansprüche, wobei
das zweite Teilwiderlager (22) eine Mindestdicke von 0,2 cm, vorzugsweise von 1 cm aufweist.

6. Vorrichtung nach einem der vorhergehenden Ansprüche, wobei
die Halteeinrichtung (3) als eine mechanische Klemmeinrichtung (30) und alternativ oder zusätzlich als pneumatische Ansaugeinrichtung (32) ausgebildet ist.

7. Vorrichtung nach einem der vorhergehenden Ansprüche, wobei
die Kontaktstelle (620) mindestens eine Fläche von 2 mm², vorzugsweise von 5 mm², aufweist.

8. Vorrichtung nach einem der vorhergehenden Ansprüche, wobei
das zweite Teilwiderlager (22) eine Härte von Shore-A 60 bis Shore-D 80, vorzugsweise von Shore-A 80 bis Shore-A 95, aufweist.

9. Vorrichtung nach einem der vorhergehenden Ansprüche, wobei
das zweite Teilwiderlager (22) aus einem Kunststoff, vorzugsweise einem Polyurethan, vorzugsweise einem Polyurethan-Elastomer, vorzugsweise einem Polyurethan-Elastomer auf Polyetherbasis, besteht.

10. Verfahren zur Herstellung eines Leistungshalbleitermoduls mit einem Bodenelement (6), das als ein Substrats (60) oder als eine Grundplatte (68) mit einem darauf befindlichem Substrat (60) ausgebildet ist, mit einem Anschlusselement (80) zur elektrischen Verbindung, wobei das Anschlusselement (80) ein Kontaktfuß (82) aufweist, der mittels einer Vorrichtung gemäß einem der vorhergehenden Ansprüche mit einer zugeordneten Kontaktstelle (620) einer Leiterbahn (62) des Substrats (60) schweißtechnisch verbunden wird.

11. Verfahren nach Anspruch 10, wobei
das Anschlusselement (80) aus Kupfer oder einer Kupferlegierung besteht.

12. Verfahren nach einem der Ansprüche 10 oder 11, wobei
die Leiterbahn (80) aus Kupfer oder einer Kupferlegierung besteht.

13. Verfahren nach einem der Ansprüche 10 bis 12, wobei
das Bodenelement (6) in Längsrichtung mindestens eine erste Vorbiegung (682) aufweist.

14. Verfahren nach einem der Ansprüche 10 bis 13, wobei
das Bodenelement (6) in Querrichtung mindestens eine zweite Vorbiegung (684) aufweist.

## Claims

1. Apparatus (1) for connecting a connection element (80) to a conductor track (62) of a substrate (60) by welding, wherein the apparatus has:
• an abutment (2) for the arrangement of a bottom element (6) which is in the form of a substrate (60) or in the form of a base plate (68) with a substrate (60) located on it, wherein the abutment (2) has a first and a second partial abutment (20, 22), wherein the first partial abutment (20) is a metal shaped body with a modulus of elasticity of between 50 and 300 kN/mm², and the second partial abutment (22) is an elastic shaped body with a modulus of elasticity of between 10 and 500 N/mm², and wherein the bottom element (6) rests on the second partial abutment (22);
• a holding device (3) which is designed to fix the bottom element (6) on the abutment (2);
• a sonotrode (5);
• a positioning device (4) for positioning the connection element (80) in relation to the substrate (60) in such a way that a contact foot (82) of the connection element (80) rests on a contact point (620) of a conductor track (62) of the substrate (60) and can be connected to said contact point by means of the sonotrode (5).

2. Apparatus according to Claim 1, wherein
the base element (6) rests exclusively on the second partial abutment (22).

3. Apparatus according to Claim 1 or 2, wherein
the modulus of elasticity of the second partial abutment (22) is between 25 and 100 N/mm².

4. Apparatus according to one of the preceding claims, wherein
the first and the second partial abutment (20, 22) are mechanically connected to one another, preferably by means of a screw connection.

5. Apparatus according to one of the preceding claims, wherein
the second partial abutment (22) has a minimum thickness of 0.2 cm, preferably of 1 cm.

6. Apparatus according to one of the preceding claims, wherein
the holding device (3) is in the form of a mechanical clamping device (30) and, as an alternative or in addition, is in the form of a pneumatic intake device (32) .

7. Apparatus according to one of the preceding claims, wherein
the contact point (620) has at least a surface area of 2 mm², preferably of 5 mm².

8. Apparatus according to one of the preceding claims, wherein
the second partial abutment (22) has a hardness of Shore A 60 to Shore D 80, preferably of Shore A 80 to Shore A 95.

9. Apparatus according to one of the preceding claims, wherein
the second partial abutment (22) is composed of a plastic, preferably a polyurethane, preferably a polyurethane elastomer, preferably a polyether-based polyurethane elastomer.

10. Method for producing a power semiconductor module having a bottom element (6) which is in the form of a substrate (60) or in the form of a base plate (68) with a substrate (60) located on it, having a connection element (80) for electrical connection, wherein the connection element (80) has a contact foot (82) which is connected to an associated contact point (620) of a conductor track (62) of the substrate (60) by welding by means of an apparatus according to one of the preceding claims.

11. Method according to Claim 10, wherein
the connection element (80) is composed of copper or a copper alloy.

12. Method according to either of Claims 10 and 11, wherein
the conductor track (80) is composed of copper or a copper alloy.

13. Method according to one of Claims 10 to 12, wherein
the bottom element (6) has at least a first pre-bent portion (682) in the longitudinal direction.

14. Method according to one of Claims 10 to 13, wherein
the bottom element (6) has at least a second pre-bent portion (684) in the transverse direction.

## Revendications

1. Arrangement (1) pour l'assemblage par technique de soudage d'un élément de raccordement (80) avec une piste conductrice (62) d'un substrat (60), l'arrangement possédant :
* une butée d'appui (2) servant à la disposition d'un élément de fond (6), qui est réalisé sous la forme d'un substrat (60) ou sous la forme d'une plaque de base (68) sur laquelle se trouve un substrat (60), la butée d'appui (2) possédant une première et une deuxième butée d'appui partielle (20, 22), la première butée d'appui partielle (20) étant un corps façonné métallique ayant un module d'élasticité entre 50 et 300 kN/mm² et la deuxième butée d'appui partielle (22) étant un corps façonné élastique ayant un module d'élasticité entre 10 et 500 N/mm² et l'élément de fond (6) reposant sur la deuxième butée d'appui partielle (22) ;
* un dispositif de maintien (3) qui est configuré pour immobiliser l'élément de fond (6) sur la butée d'appui (2) ;
* une sonotrode (5) ;
* un dispositif de positionnement (4) destiné à positionner l'élément de raccordement (80) par rapport au substrat (60) de telle sorte qu'un pied de contact (82) de l'élément de raccordement (80) repose sur un point de contact (620) d'une piste conductrice (62) du substrat (60) et peut être relié à celui-ci au moyen de la sonotrode (5).

2. Arrangement selon la revendication 1, l'élément de fond (6) reposant exclusivement sur la deuxième butée d'appui partielle (22).

3. Arrangement selon la revendication 1 ou 2, le module d'élasticité de la deuxième butée d'appui partielle (22) étant compris entre 25 et 100 N/mm².

4. Arrangement selon l'une des revendications précédentes, la première et la deuxième butée d'appui partielle (20, 22) étant assemblées l'une à l'autre mécaniquement, de préférence au moyen d'un assemblage vissé.

5. Arrangement selon l'une des revendications précédentes, la deuxième butée d'appui partielle (22) possédant une épaisseur minimale de 0,2 cm, de préférence de 1 cm.

6. Arrangement selon l'une des revendications précédentes, le dispositif de maintien (3) étant réalisé sous la forme d'un dispositif de serrage mécanique (30) et, en variante ou en complément, sous la forme d'un dispositif d'aspiration pneumatique (32).

7. Arrangement selon l'une des revendications précédentes, le point de contact (620) possédant au moins une surface de 2 mm², de préférence de 5 mm².

8. Arrangement selon l'une des revendications précédentes, la deuxième butée d'appui partielle (22) possédant une dureté de Shore-A 60 à Shore-D 80, de préférence de Shore-A 80 à Shore-A 95.

9. Arrangement selon l'une des revendications précédentes, la deuxième butée d'appui partielle (22) se composant d'une matière plastique, de préférence d'un polyuréthane, de préférence d'un polyuréthane-élastomère, de préférence d'un polyuréthane-élastomère à base de polyéther.

10. Procédé de fabrication d'un module semiconducteur de puissance comprenant un élément de fond (6), qui est réalisé sous la forme d'un substrat (60) ou sous la forme d'une plaque de base (68) sur laquelle se trouve un substrat (60), comprenant un élément de raccordement (80) servant à la connexion électrique, l'élément de raccordement (80) possédant un pied de contact (82) qui est relié par technique de soudage à un point de contact (620) associé d'une piste conductrice (62) du substrat (60) au moyen d'un arrangement selon l'une des revendications précédentes.

11. Procédé selon la revendication 10, l'élément de raccordement (80) se composant de cuivre ou d'un alliage de cuivre.

12. Procédé selon l'une des revendications 10 ou 11, la piste conductrice (80) se composant de cuivre ou d'un alliage de cuivre.

13. Procédé selon l'une des revendications 10 à 12, l'élément de fond (6) possédant au moins un premier précintrage (682) dans la direction longitudinale.

14. Procédé selon l'une des revendications 10 à 13, l'élément de fond (6) possédant au moins un deuxième précintrage (684) dans la direction transversale.
